Europäisches Patentamt

European Patent Office

Office européen des brevets

(11) Publication number: **0 128 981**
**B1**

(12) **EUROPEAN PATENT SPECIFICATION**

(45) Date of publication of patent specification: **26.04.89**

(21) Application number: **83303495.2**

(22) Date of filing: **16.06.83**

(51) Int. Cl.⁴: **H 01 L 21/48, B 23 K 20/22**

(54) **Multi-gauge metal strip, method of forming same and leadframes produced therefrom.**

(43) Date of publication of application:
**27.12.84 Bulletin 84/52**

(45) Publication of the grant of the patent:
**26.04.89 Bulletin 89/17**

(84) Designated Contracting States:
**DE FR GB IT**

(56) References cited:
**US-A-3 992 977**
**US-A-3 999 955**
**US-A-4 055 062**

(73) Proprietor: **Olin Corporation**
**427 North Shamrock Street**
**East Alton Illinois 62024 (US)**

(72) Inventor: **Tatum, Robert N.**
**14660 Mill Spring Drive**
**Chesterfield Missouri 63017 (US)**
Inventor: **Hofer, Robert W.**
**89 Oak Drive**
**Watertown Connecticut 06795 (US)**
Inventor: **Zarlingo, S. Paul**
**2850 Idaho**
**Granite City Illinois 62040 (US)**

(74) Representative: **Lambert, Hugh Richmond et al**
**D. YOUNG & CO. 10 Staple Inn**
**London, WC1V 7RD (GB)**

Courier Press, Leamington Spa, England.

## Description

This invention relates to the formation of multi-gauge strip suitable for the manufacture of electrical leadframes.

The particular type of leadframe with which the present invention is concerned has the dual requirement of high strength and high thermal conductivity. Typically, the high thermal conductivity is required to dissipate heat from an electronic device mounted or connected to the leadframe. Failure to dissipate sufficient heat may cause malfunction of the electronic device. In addition, high strength is required so that the leadframe can be handled both manually and automatically without distortion of the leadframe.

In the past, different metals used to construct leadframes provided sufficient conductivity but compromised the desired strength. In other cases, sufficient strength was obtained, but the metal lacked the desired conductivity. The problem is further complicated by the requirement that the leadframes have "thick and thin portions". A thick gauge provides improved heat dissipation while a thin gauge, being more easily formed and soldered, provides connecting legs. The present invention provides a multi-gauge strip which fulfills all the above-mentioned requirements by bonding two different strips of metal and machining them to different gauges essentially as a continuous operation.

The technique used herein to bond the two different metal strips is itself known, and is disclosed in US-A-3,381,364 and US-A-3,397,045. This technique involves rolling the two strips together to form a metal-to-metal bond between them without the use of an intervening material such as a welding or brazing material.

Moreover, such a bonding technique has been used, see US-A-3,826,627, in the production of decorative metal laminates, and involving a subsequent machining or chemical etching step in which portions of the overlying layer are removed in an essentially batch-wise, rather than continuous, operation, to expose the underlying layer. This, however, is merely a temporary measure, the machined or etched areas being filled in subsequently by the application of a glass or ceramic coating to the bonded laminate.

Finally, in US-A-3,992,977 a shaving technique is disclosed which comprises continuously shaving a strip along its length to form a multi-gauge product, but of a single, homogenous metal strip, not of a bonded composite of two different metals.

Other prior art to be acknowledged includes:

US-A-3,630,429 which discloses an apparatus to form composite metal wire consisting of a steel wire or the like cladded with a metal covering of aluminium or other metals;

US-A-3,465,419 which discloses, for example, a method of making decorative metal stock wherein a plurality of metal layers are bonded together by known bonding techniques and recessing certain selective area portions of the laminated cladding by machinery, drilling, or grinding; and

US-A-3,202,588 which discloses a method of making decorative metal sheet wherein two layers of material are metallurgically bonded together, a protective coating applied to selected areas of the exposed surface of one of the layers and removal in the uncoated areas by grinding, milling, or etching.

The present invention seeks to provide an improved and simplified form of multi-gauge strip useful in the manufacture of leadframes and to provide a method of forming such strip which substantially obviates one or more of the limitations and disadvantages of the described prior arrangements, and which in particular can operate in a continuous manner to produce multi-gauge metal strip both quickly and efficiently and, therefore, economically.

In one aspect of the invention, there is provided a method of forming multi-gauge metal strip suitable for use in the production of metal leadframes, which comprises the steps of:

(i) superimposing two metal or alloy strips one on top of the other in direct face-to-face contact, the underlying strip being of lesser thickness than the overlying strip, and of lesser thermal conductivity, but of a higher strength metal or alloy than that of the overlying strip;

(ii) pressure bonding the two strips together without the use of welding or brazing material, thereby to form a direct metal-to-metal bond between the two superimposed strips; and

(iii) machining one or more grooves along the length of the composite bonded strip, said groove(s) being machined in and extending through the thickness of the second strip thereby exposing the surface of the underlying strip along the length of the groove.

After machining, the bonded strip can be slit along the grooves and/or between adjacent grooves to provide a plurality of multi-gauge strips preferably all of identical cross section, and thereafter stamped to form individual leadframes having the characteristics above described.

Also provided in accordance with the invention is a multi-gauge metal strip useful in the production of metal leadframes comprising two superimposed strips of metal of different thicknesses, strength and the thermal conductivity pressure bonded together in direct metal-to-metal contact without the use of welding or brazing material, the thicker of said strips being narrower than the other, thinner strip, thereby providing a composite bonded multi-gauge strip having across its width a first section having a thickness substantially equal to the thickness of the thinner of said two strips and a second section having a thickness substantially equal to the sum of the thicknesses of the two strips, said thinner strip having a higher strength than the thicker strip but being of lesser thermal conductivity.

Preferred embodiments of the invention will now be described with reference to the accompanying drawings, in which:

Figure 1 is a flow chart of the general method of this invention;

Figure 2 is a cross-section of two bonded strips of material;

Figure 3 is a perspective view of a shaved bonded strip before slitting;

Figure 4 is a perspective view of a multi-gauge strip;

Figure 5 is a top view of a stamped leadframe; and

Figure 6 is a view of a multi-gauge strip having a slot in accordance with the present invention.

In accordance with the present invention, a multi-gauge strip 10 is provided. The multi-gauge strip includes an underlying strip of metal 12 (hereinafter referred to as the first strip) having a first thickness 14 and extending longitudinally for a given length 16. An overlying strip of metal 18 (hereinafter referred to as the second strip) having a second thickness 20, is narrower in width 22 than the substantially constant width 23 of the first strip, and coextends longitudinally with the first strip of metal 12. The first and second strips of metals 12 and 18 are intimately bonded in direct metal-to-metal contact without the use of a welding or brazing material whereby the multi-gauge strip 10 has a first portion 24 extending the given length 16 having a third thickness 26 substantially equal to the sum of the first and second thicknesses 14 and 20, respectively. The multi-gauge strip also has a second portion 28 of substantially constant width 30 extending the given length 16 and having a fourth thickness 32 substantially equal to the first thickness 14.

The present invention is concerned with producing a multi-gauge strip which is ideally suited to form a particular family of leadframes having the dual requirement of high strength and high thermal conductivity. Typically, when a given metal has sufficient conductivity, it lacks the desired strength Similarly, in a given metal having sufficient strength, the metal lacks the desired conductivity. Further, the leadframes have thick and thin gauges. The thick gauge is useful for conduction, while the thin gauge, being formable and solderable, is useful for connecting legs. The present invention provides a process to quickly and efficiently form multi-gauge strip having both high conductivity and strength.

The first strip 12 is formed of a material having high strength and sufficient thermal and electrical conductivity. This material is preferably a copper alloy such as C510, C762 or C725. Since this material is used to form the connecting legs 34 of a leadframe requiring formability and solderability, the gauge is relatively thin. Due to the standards of the electronic industry, the legs usually have a thickness of either 0.015 inch or 0.018 inch (0.381 and 0.457 mm respectively). Accordingly, this is the preferred thickness of the material of the first strip 12. Of course, it is within the scope of the present invention to form the strip 12 of other alloys or metals and of other thicknesses.

The second strip 18 is formed of a high thermal and electrically conductive material such as C1092, C1094 or C110. Since the strip 18 is used as a heat sink, it is thicker than the strip 12. Due to the standards of the industry with respect to the dimensions of leadframes, such as leadframe 36, the thickness 20 of the strip 18 is preferably 0.050 inch (1.27 mm). It is within the scope of the present invention to form the strip 18 of other materials such as metals or alloys which have the characteristic of high electrical and thermal conductivity.

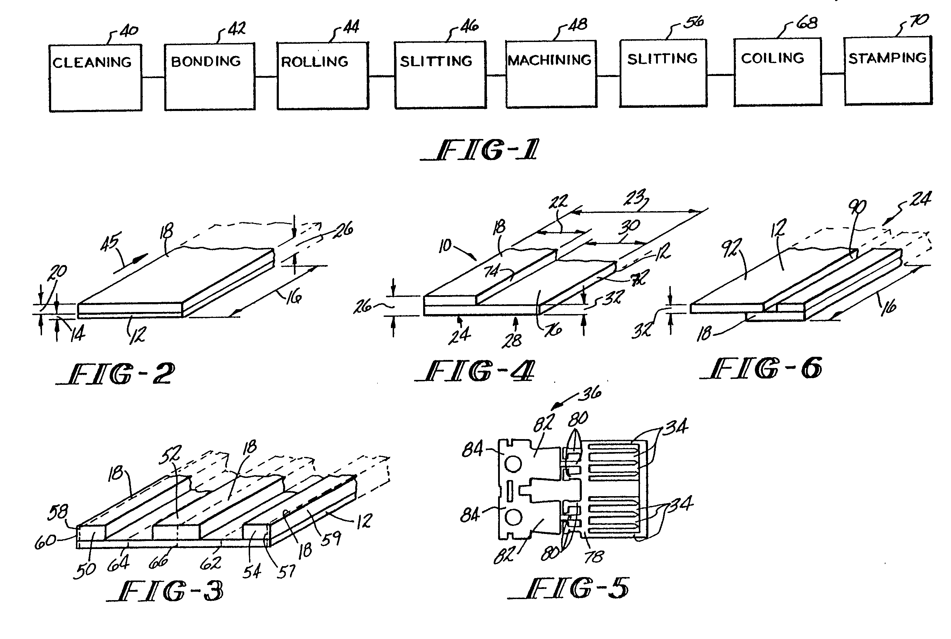

In order to more fully understand the process by which multi-gauge strip 10 is manufactured and formed into the leadframe 36 as shown in Figure 5 a detailed exemplary description follows. Referring to the flow diagram of Figure 1, block 40 represents a cleaning station where the metals may be cleaned preparatory to joining. The cleaning process may be in accordance with that described in US-A-3,397,045 which includes a wet chemical cleaning treatment to degrease the metal surface. For example, the metal may be immersed in a degreasing solvent such as trichlorethylene or in an inhibited solution of an alkaline cleaning agent such as a solution of trisodium phosphate in water at 160°F (71°C). In addition, the surfaces to be joined may be mechanically cleaned and roughened by mechanical wire brushing in accordance with the latter reference if so desired. Although these processes may be desirable, they are not necessarily required and may be omitted if so desired.

The two strips of metal then move to a bonding station represented by block 42. At this station, the strips are intimately bonded in direct metal-to-metal contact without the use of a welding or brazing material. This bonding may be accomplished in accordance with the posit bonding principles as set forth in US-A-3,397,045 and US-A-3,381,364. As described in those patents, the two strips of material are fed into a rolling mill at different speeds to form an integrated composite strip of material where the direct metal-to-metal contact is a substantially diffusionless interatomic bond. The integral composite sheet metal strip which is formed has good bond strength with the core and cladding being bonded together in direct metal-to-metal contact. The interface between the core and cladding is characterized by having greater contact area between the core and the cladding than between planar sheets and having a wave-like interface with a plurality of peaks. The peaks are irregular in distribution and have greater length than height.

After the strip is bonded, the thickness 26 of the composite strip may be greater than desired. In this instance, the strip of material is preferably run through a rolling mill station represented by block 44 where it is reduced to the proper thickness of approximately 0.050 inch (1.27 mm). Of course, it may not be necessary to provide this station as the rolling mill used for the bonding process may have already formed the strip to the desired thickness. In either case, the resulting strip will have a first layer formed of the first strip of metal and a second layer formed of the second strip of metal. The resulting strip will have a given length 16, preferably very long, and a general configuration as shown in Figure 2. Specifically, the first strip 12 will have a first thickness 14 which is preferably either 0.015 inch or 0-018 inch (0.381 or 0.457 mm) as described above. The second strip 18 will have a second thickness 20 which is preferably 0.035 inch (0.889 mm). Also, the length of the bonded strip will extend in a longitudinal direction indicated by arrow 45 for some given length 16. At this stage of the process the strip may be approximately 16 inches (41 cms) wide.

The strip may then be fed through a slitting station indicated by block 46 where the strip is slit into four longitudinal bonded strips having parallel outer edges. The slitting may be accomplished by any conventional device such as the slitters shown and described in US-A-3,706,246. Although this slitting operation is frequently required, it is within the scope of the present invention to forego this step in the event that the strip, which has been bonded and if necessary rerolled, is already the proper width.

The strip now enters a machining station indicated by block 48 where the machining is performed by draw shaving in accordance with the method and apparatus as taught in US-A-3,992,977. The method disclosed in that patent produces a multiple gauge metal strip product of rectangular cross section possessing regions of two or more variable thicknesses providing a generally stepped surface configuration. The maximum possible stock removal per pass in relation to the yield strength of the strip is determined by measuring the amount of the stock removed up to the point where yielding of the strip occurs under tension. The apparatus for shaving the strip is adjusted to remove approximately the maximum possible stock in a single shaving pass without causing the metal strip to exceed its yield strength. The strip is drawn under back tension through the apparatus and shaved to reduce by an amount confined to an area comprising from approximately 5 to about 50% of the total surface area. The volume of the strip removed ranges from approximately 10 to about 60% as measured in relation to initial strip cross section area. The shaving tool device described in the latter reference reduces the volume of the second strip 18 in a manner as shown in the example of Figure 3. This shaving technique has certain important advantages over conventional milling procedures in removing material in a longitudinal direction from the bonded strip. The advantages include higher speeds of operation, easier scrap retrieval, and fewer passes in less time. The strip passes through the shaving apparatus one or more times as required until longitudinal sections of the second strip of metal 18 are removed for the given length 16 of the strip to a depth whereby the first strip of metal 12 is exposed. It is frequently necessary to run the strip through the shaving apparatus a number of times in order to remove the desired amount of material without exceeding the yield strength of the strip whereby it may rupture. This can be understood by referring to Figure 3 where two longitudinal sections have been removed leaving three remaining longitudinal sections 50, 52 and 54 of the second strip of metal 18. It is within the scope of the present invention to provide any desired configuration of the strip, after it has left the machining or shaving station 48, as a matter of choice. For instance, there may be more or less grooves cut into the strip at either less or greater thicknesses.

The shaved strip may then be fed into a station 56 where it is slit in the manner described for station 46. In the example described herein, the strip as shown in Figure 3 could be slit into six separate strips of material by a total of five slits 57, 58, 62, 64 and 66; two of these slits 57 and 58 would preferably be very close to the outer edges 59 and 60 respectively, of the strip in order to remove any excess material from the outer resulting multi-gauge strips. Two additional slits. at locations designated as 62 and 64, would be centred between longitudinal sections 50, 52 and 54. The final slit would be through the centre of the section 52 through the dotted line 66. The result of this slitting operation would be four, substantially identical, multi-gauge strips with a configuration as shown in Figure 4, and two waste strips from the outer edges. It should be noted that although the slitting operation at station 56 may be independent from the shaving operation at station 48, the slitting apparatus may be incorporated directly into the line with the shaving apparatus whereby the strip is slit immediately after it has been shaved down to the proper dimensions.

Finally, the strip may be coiled at station 68 into rolls of finished multi-gauge strip. Of course, it is not necessary that the strip be coiled, but it may be stored in any other desired manner.

Referring to Figure 4, there is illustrated a section of the finished multi-gauge strip in accordance with the example set forth herein. As mentioned hereinabove, the multi-gauge strip includes a first and second portion 24 and 28, respectively. The second portion 28 extends from the first portion to the longitudinal outer edge 72 of the first strip 12 of material. The longitudinal outer edge 74 of the first portion 24, formed by the second strip 18, is illustrated and preferably extends at an approximate 90° angle to the top surface 76 of the first strip 12 in the second portion 28. However, it is within the scope of the invention to provide any preferred angle.

Once the multi-gauge strip is formed, it may be stamped out at a station 70 to form a leadframe such as the type illustrated in Figure 5. The stamping equipment may be of any conventional design. The leadframe is preferably used for mounting electric devices such as semi-conductors wherein the first strip of metal 12 of the second portion 28 is formed into legs 34. These legs are joined to a dam bar 78 which is connected to the second portion 24 by a plurality of connection leads 80. It can be appreciated that the second portion represented by 28 in Figure 4 includes the connecting legs 34, the dam bar 78, and the connection leads 80. Accordingly, all of these have the same general thickness equal to the thickness 32 of the first strip 12. The second strip of metal 18 which partially forms the first portion 24 is adapted to be a mounting surface 82 for an electronic device (not shown). Since the second strip is an excellent conductor, it facilitates heat dissipation from the electronic device (not shown). The leadframe also includes cooling fins 84. The illustrated leadframe is only exemplary and alternative configurations may be just as easily produced.

Another embodiment of the present invention, as shown in Figure 6, includes a longitudinal slot 90 in the first strip of metal 12 within the first portion 24. The number designations are the same as the first embodiment where the same element is represented. The longitudinal slot 90 extends the given length 16 and has a minimum depth equal to the first thickness 32. The exposed inner surface of the second strip of material 18 has a length substantially equal to the slot 90 and is exposed through the slot. Of course, it is within the scope of the present invention to selectively remove metal at other propitious spots whereby electronic devices may be connected to both the surface 92 of the material 12 and to the second strip 18.

## Claims

1. A method of forming a multi-gauge metal strip suitable for use in the production of metal leadframes, comprising the steps of:

(i) superimposing two metal or alloy strips (12, 18) one on top of the other in direct face-to-face contact, the underlying strip (12) being of lesser thickness than the overlying strip (18), and of lesser thermal conductivity, but of a higher strength metal or alloy than that of the overlying strip;

(ii) pressure bonding the two strips (12, 18) together without the use of welding or brazing material, thereby to form a direct metal-to-metal bond between the two superimposed strips; and

(iii) machining one or more grooves along the length of the composite bonded strip, said groove(s) being machined in and extending through the thickness of the overlying the strip (18) thereby exposing the surface of the underlying strip (12) along the length of the groove.

2. A method according to claim 1, characterised in that after machining the composite bonded strip is slit (62, 64, 66) along the length of the groove or grooves and/or along the length of the strip between two adjacent parallel grooves to provide a plurality of multi-gauge strips.

3. A method according to claim 2, characterised in that the plurality of multi-gauge strips produced by machining and slitting the composite bonded strip all have substantially identical cross sections.

4. A method according to claim 3, characterised in that before or after machining the composite bonded strip is additionally slit (57, 58) along both longitudinal edges to provide the composite bonded strip with substantially parallel edges.

5. A method according to any one of claims 1 to 4, characterised in that said groove or grooves are formed in the composite bonded strip by draw shaving the strip in one or more passes through a shaving machine.

6. A method according to any one of claims 1 to 5, including the additional step of stamping the multi-gauge strip to form a plurality of leadframes (36) each having a thick thermal sink portion (82, 84) constituted by un-machined portions of the two superimposed bonded strips, and thinner electrical lead portions (34, 80) constituted by sections of the underlying strip (12) exposed by the machining away of the overlying strip (18).

7. A multi-gauge metal strip suitable for use in the manufacture of leadframes, characterised in that it comprises two superimposed strips of metal (12, 18) of different thicknesses, strength and thermal conductivity pressure bonded together in direct metal-to-metal contact without the use of welding or brazing material, the thicker of said strips (18) being narrower than the other, thinner strip (12), thereby providing a composite bonded multi-gauge strip having across its width a first section (28) having a thickness substantially equal to the thickness of the thinner of said two strips and a second section (24) having a thick-ness substantially equal to the sum of the thicknesses of the two strips, said thinner strip (12) having a higher strength than the thicker strip (18) but being of lesser thermal conductivity.

8. A multi-gauge metal strip according to claim 7, characterised in that the narrower (18) of the two superimposed strips is positioned in the bonded strip with one of its longitudinal edges in alignment with one of the longitudinal edges of the wider strip (12).

9. A multi-gauge metal strip according to claim 7 or 8, characterised in that the wider of the two superimposed and bonded strips (12) has at least one longitudinal groove (90) formed therein of a sufficient depth to expose the surface of the narrower strip (18) along the length of the multi-gauge strip.

10. A leadframe formed by stamping from a strip according to claim 7, 8 or 9, said leadframe having at least one thick thermal sink portion (82, 84) constituted by the two superimposed bonded strips, and at least one electrial lead portion constituted by the exposed portion of the thinner (12) of the two strips.

## Patentansprüche

1. Verfahren zur Bildung eines mehrere Dicken aufweisenden Metallstreifens, der zur Verwendung bei der Herstellung von Metall-Leiterrahmen geeignet ist, mit folgenden Schritten:

(i) Übereinanderlegen zweier Streifen (12, 18) aus Metall oder einer Legierung in direktem flachseitigen Kontakt aufeinander, wobei der unten liegende Streifen (12) eine geringere Dicke als der oben liegende Streifen (18) sowie eine geringere Wärmeleitfähigkeit als dieser aufweist, jedoch aus einem Metall oder einer Legierung mit einer höheren Festigkeit als der des oben liegenden Streifens gebildet ist;

(ii) unter Druck erfolgendens miteinander Verbinden der beiden Streifen (12, 18) ohne Verwendung von Schweißoder Hartlötmaterial, um dadurch eine direkte Metall-an-Metall-Verbindung zwischen den beiden übereinanderliegenden Streifen zu bilden; und

(iii) zerspanende Einarbeitungeiner oder mehrerer Nuten entlang der Länge des zusammengesetzten Verbundstreifens, wobei die Nut(en) dem oben liegenden Streifens (18) zerspanend ausgebildet wird (werden) und sich durch dessen Dicke hindurcherstreckt (-erstrecken), um dadurch die Oberfläche des darunterliegenden Streifens (12) entlang der Länge der Nut freizulegen.

2. Verfahren nach Anspruch 1, dadurch gekennzeichnet, daß der zusammengesetzte Verbundstreifen nach der zerspanenden Bearbeitung entlang der Länge der Nut oder Nuten und/oder entlang der Länge des Streifens zwischen zwei einander benachbarten, parallelen Nuten zur Schaffung einer Mehrzahl von mehrere Dicken aufweisenden Streifen zerteilt wird.

3. Verfahren nach Anspruch 2, dadurch gekennzeichnet, daß die durch zerspanende Bearbeitung und Zerteilen des zusammengesetzten Verbundstreifens gebildete Mehrzahl von mehrere Dicken aufweisenden Streifen alle im wesentlichen denselben Querschnitt besitzen.

4. Verfahren nach Anspruch 3, dadurch gekennzeichnet daß vor oder nach der zerspanenden Bearbeitung der zusammengesetzte Verbundstreifen zusätzlich entlang beider Längskanten beschnitten wird (57, 58), um dem zusammengesetzten Verbundstreifen im wesentlichen parallele Kanten zu verleihen.

5. Verfahren nach einem der Ansprüche 1 bis 4, dadurch gekennzeichnet, daß die Nut oder Nuten in dem zusammengesetzten Verbundstreifen durch Zieh-Abspanen des Streifens in einem oder mehreren Durchläufen durch eine Abspanmaschine gebildet werden.

6. Verfahren nach einem der Ansprüche 1 bis 5, mit dem zusätzlichen Schritt, daß der mehrere Dicken aufweisende Streifen zur Bildung einer Mehrzahl von Leiterrahmen (36) zerstanzt wird, wobei jeder Leiterrahmen einen dicken Wärmesenkenbereich (82, 84), der durch nicht zerspanend bearbeitete Bereiche der beiden übereinanderliegenden, miteinander verbundenen Streifen gebildet wird, sowie dünnere elektrische Leiterbereiche (34, 80) aufweist, die durch Abschnitte des unten liegenden Streifens (12) gebildet werden, welche durch zerspanende Wegarbeitung des oben liegenden Streifens (18) freigelegt sind.

7. Mehrere Dicken aufweisender Metallstreifen, der zur Verwendung bei der Herstellung von Leiterrahmen geeignet ist, dadurch gekennzeichnet, daß er zwei übereinanderliegende Streifen aus Metall (12, 18) unterschiedlicher Dicken, Festigkeit und Wärmeleitfähigkeit umfaßt, die ohne Verwendung von Schweiß- oder Hartlötmaterial in direktem Metall-an-Metall-Kontakt unter Druck miteinander verbunden sind, wobei der dickere der Streifen (18) schmaler als der andere, dünnere Streifen (12) ist, um dadurch einen zusammengesetzten, mehrere Dicken aufweisenden Verbundstreifen zu schaffen, der über seine Breite einen ersten Abschnitt (28), dessen Dicke im wesentlichen der Dicke des dünneren der beiden Streifen entspricht, sowie einen zweiten Abschnitt (24), dessen Dicke im wesentlichen der Summe der Dicken der beiden Streifen entspricht, aufweist, wobei der dünnere Streifen (12) eine höhere Festigkeit als der dickere Streifen (18) besitzt, jedoch eine geringere Wärmeleitfähigkeit als dieser aufweist.

8. Mehrere Dicken aufweisender Metallstreifen nach Anspruch 7, dadurch gekennzeichnet, daß der schmalere (18) der beiden übereinanderliegenden Streifen in dem Verbundstreifen derart positioniert ist, daß eine seiner Längskanten mit einer der Längskanten des breiteren Streifens (12) ausgerichtet ist.

9. Mehrere Dicken aufweisender Metallstreifen nach Anspruch 7 oder 8, dadurch gekennzeichnet, daß der breitere der beiden übereinanderliegenden und miteinander verbundenen Streifen (12) wenigstens eine darin ausgebildete Längsnut (90) aufweist, die eine ausreichende Tiefe besitzt, um die Oberfläche des schmaleren Streifens (18) entlang der Länge des mehrere Dicken aufweisenden Streifens freizulegen.

10. Durch Stanzen aus einem Streifen nach Anspruch 7, 8 oder 9 gebildeter Leiterrahmen, wobei der Leiterrahmen wenigstens einen dicken Wärmesenkenbereich (82, 84), der durch die beiden übereinanderliegenden, miteinander verbundenen Streifen gebildet ist, sowie wenigstens einen elektrischen Leiterbereich, der durch den freiliegenden Bereich des dünneren (12) der beiden Streifen gebildet ist, aufweist.

**Revendications**

1. Procédé pour produire une bande métallique ayant plusieurs épaisseurs, utilisable dans la fabrication de châssis métalliques à connexions, comprenant les opérations consistant à:

(i) superposer deux bandes (12, 18) de métal ou d'alliage l'une sur l'autre, de manière qu'elles soient directement en contact face à face, la bande du dessous ou bande inférieure (12) ayant une plus faible épaisseur que la bande du dessus ou bande supérieure (18) et une conductivité thermique moindre, mais étant constituée d'un métal ou d'un alliage de plus grande résistance mécanique que celui de la bande supérieure;

(ii) assembler par pression les deux bandes (12, 18), sans utiliser un matériau de soudage ou de brasage, de manière à établir une liaison directe métal à métal entre les deux bandes superposées; et

(iii) usiner une ou plusieurs rainures sur toute la longueur de la bande composite obtenue par cet assemblage, cette rainure ou chacune de ces rainures étant usinée dans et s'étendant à travers toute l'épaisseur de la bande supérieure (18), de manière que la surface de la bande inférieure (12) soit exposée sur toute la longueur de la rainure.

2. Procédé selon la revendication 1, caractérisé en ce que, après l'usinage, la bande composite est fendue (62, 64, 66) sur toute la longueur de la rainure ou de chaque rainure et/ou sur toute la longueur de la bande entre deux rainures parallèles voisines, de manière à produire un certain nombre de bandes ayant plusieurs épaisseurs.

3. Procédé selon la revendication 2, caractérisé en ce que les bandes à plusieurs épaisseurs, produites par l'usinage et le fendage de la bande composite, possèdent toutes des sections droites sensiblement identiques.

4. Procédé selon la revendication 3, caractérisé en ce que, avant ou après l'usinage, la bande composite est fendue en plus (57, 58) le long des deux bords longitudinaux, de manière à doter la bande composite de bords sensiblement parallèles.

5. Procédé selon l'une quelconque des revendications 1 à 4, caractérisé en ce que la rainure ou chaque rainure est formée dans la bande composite par un rabotage à tirage de la bande composite en une ou plusieurs passes dans une raboteuse.

6. Procédé selon l'une quelconque des revendications 1 à 5, comprenant l'opération supplémentaire consistant à découper la bande ayant plusieurs épaisseurs, de manière à créer les châssis à connexions (36), possédant chacun une partie épaisse (82, 84) formant dissipateur thermique, constituée par des portions non usinées des deux bandes superposées et assemblées, ainsi que des parties plus minces, formant des connexions électriques (34, 80), qui sont constituées par des sections de la bande inférieure (12) exposées par l'enlèvement partiel par usinage de la bande supérieure (18).

7. Bande métallique ayant plusieurs épaisseurs, utilisable dans la fabrication de châssis à connexions, caractérisée en ce qu'elle est composée de deux bandes de métal (12, 18) superposées, ayant des épaisseurs, des résistances mécaniques et des conductivités thermiques différentes, qui sont assemblées par pression, de manière à être directement en contact métal à métal, sans l'utilisation de matériau de soudage ou de brasage, la bande plus épaisse (18) étant plus étroite que l'autre bande (12), plus mince, l'assemblage produisant une bande composite ayant plusieurs épaisseurs et comprenant, dans le sens de sa largeur, une première section (28) dont l'épaisseur est sensiblement égale à l'épaisseur de la bande plus mince des deux bandes, ainsi qu'une seconde section (24) dont l'épaisseur est sensiblement égale à la somme des épaisseurs des deux bandes, la bande plus mince (12) ayant une résistance mécanique plus grande que la bande (18) plus épaisse, mais ayant une conductivité thermique moindre.

8. Bande selon la revendication 7, caractérisée en ce que la bande plus étroite (18) des deux bandes superposées est disposée dans la bande composite de manière que l'un de ses bords longitudinaux soit aligné avec l'un des bords longitudinaux de la bande plus large (12).

9. Bande selon la revendication 7 ou 8, caractérisée en ce que la bande plus large (12) des deux bandes superposées et assemblées présente au moins une rainure longitudinale (90) formée dans cette bande et ayant une profondeur suffisante pour exposer la surface de la bande plus étroite (18) sur toute la longueur de la bande à plusieurs épaisseurs.

10. Châssis à connexions produit par découpage à partir d'une bande selon la revendication 7, 8 ou 9 et comprenant au moins une partie épaisse (82, 84) formant dissipateur thermique, constituée par les deux bandes superposées et assemblées, ainsi qu'au moins une partie formant connexion électrique, constituée par la partie exposée de la bande plus mince (12) des deux bandes.

CLEANING `40` — BONDING `42` — ROLLING `44` — SLITTING `46` — MACHINING `48` — SLITTING `56` — COILING `68` — STAMPING `70`

*FIG-1*

*FIG-2*

*FIG-4*

*FIG-6*

*FIG-3*

*FIG-5*

EP 0 128 981 B1